Europäisches Patentamt

European Patent Office

Office européen des brevets

(11) Veröffentlichungsnummer: **0 368 925 B1**

# (12) EUROPÄISCHE PATENTSCHRIFT

(45) Veröffentlichungstag der Patentschrift: **04.11.92**

(21) Anmeldenummer: **88907232.8**

(22) Anmeldetag: **18.08.88**

(86) Internationale Anmeldenummer:
**PCT/DE88/00508**

(87) Internationale Veröffentlichungsnummer:
**WO 89/01712 (23.02.89 89/05)**

(51) Int. Cl.⁵: **H01S 3/083**, H01S 3/09,
H01S 3/101, H04J 14/00,
H01S 3/085

(54) **LICHTVERSTÄRKER MIT RINGFÖRMIG GEFÜHRTER STRAHLUNG, INSBESONDERE RINGLASER-DIODE.**

(30) Priorität: **18.08.87 DE 3727546**

(43) Veröffentlichungstag der Anmeldung:
**23.05.90 Patentblatt 90/21**

(45) Bekanntmachung des Hinweises auf die
Patenterteilung:
**04.11.92 Patentblatt 92/45**

(84) Benannte Vertragsstaaten:
**DE FR GB IT**

(56) Entgegenhaltungen:
**US-A- 3 743 962**

**Applied Physics Letters, Vol. 29, Nr 8, 15 October 1976, American Institute of Physics (New York, US), D. BOTEZ et al. : "Optically pumped GaAs-Gal-XAlxAs half-ring laser fabricated by liquid-phase epitaxy over chemically etched channels", pages 502-504, see page 502, figure 2 (cited in the application).**

(73) Patentinhaber: **SIEMENS AKTIENGESELL-SCHAFT**
**Wittelsbacherplatz 2**
**W-8000 München 2(DE)**

(72) Erfinder: **DANIELMEYER, Günter**
**Otto-Hahn-Ring 6**
**W-8000 München 83(DE)**

Review of the Electrical Communication Laboratories, Vol. 26, Nr. 7/8, July/August 1978 (Tokio, JP), N. MATSUMOTO : "Bent guide structure semiconductor lasers", pages 1027-1044, see chapter 3.3, "Ring laser".

Patent Abstracts of Japan, Vol. 7, Nr. 229 (E-203) (1374), 12 October 1983 & JP, A, 58118183 (NIPPON DENKI K.K.), 14 July 1983, see abstract (cited in the application).

Applied Physics Letters, Vol. 36, Nr. 10, 15 May 1980, American Institute of Physics (Woodbury, New York, US), A.S.-H. LIAO et al. : "Semiconductor injection lasers with a circular resonator", pages 801-803, see pages 801-803, figure 1 (cited in the application).

EP 0 368 925 B1

**Beschreibung**

Die vorliegende Erfindung bezieht sich auf einen Lichtverstärker, insbesondere auf eine Ringlaser-Diode.

Aus dem Stand der Technik sind (ungepumpte) ringförmige optische Wellenleiter bzw. optische Ringoszillatoren (JP-OS 59-154086 und Appl. Phys. Lett. 47 (1985) S. 439 - 440) bekannt. Optisch zu pumpende Ringlaser sind beschrieben in Appl. Phys. Lett. 29 (1976) S. 502 - 504 und 43 (1983) S. 32 - 34. Besonderes Interesse besteht für durch Strominjektion zu pumpende ringförmige Laseranordnungen, sogenannte Ringlaser-Dioden, wobei dieses Prinzip die für die stimulierte Emission notwendige Besetzungsinversion durch Stromdurchgang durch einen pn-Übergang eines Halbleiterkörpers zu bewirken, bereits aus der DE-AS 12 98 216 von Heywang bekannt ist.

Ringlaser-Dioden sind beschrieben in Jap. J. Appl. Phys. 16 (1977) S. 2281 - 2282; 16 (1977) S. 1395 - 1398; Appl. Phys. Lett. 36 (1980) S. 801-803, 36 (1980) S. 353 - 355; Jour. Appl. Phys. 52 (1981) S. 4457 - 4461; JP-OS 58-118183 und 60-148185. Es sind dies Ringlaser-Dioden, bei denen das Halbleitermaterial bzw. der Halbleiterkörper entlang bzw. im Bereich einer solchen Ringzone so präpariert ist. Solche Präparationen laufen darauf hinaus, eine ringförmig ausgestaltete Indexführungen zu schaffen, wie sie vergleichsweise für geradlinige Indexführung von Laserstrahlung in Laserdioden bekannt ist. Der Vollständigkeit halber sei darauf hingewiesen, daß es für Laserdioden mit geradliniger Strahlungsausbreitung auch das Prinzip der Gewinnführung (gain guided) gibt, wo im entscheidenden Maße durch örtlich konzentrierte Stromdichteverteilung in einer geraden bzw. in einer ringförmigen Zone die notwendige Laserbedingung für diese Zone geschaffen wird.

Die Präparation eines Halbleiterkörpers mit dem Ziel eine Ringlaser-Diode zu schaffen, ist aufwendig. Es dürfte dies ein Grund sein, weshalb Ringlaser-Dioden, soweit bekannt, bisher nicht zu praktischer Anwendung gekommen sind, obwohl Ringlaser vorteilhafterweise keine solchen Spiegel oder Flächen mit wenigstens einem gewissen Reflexionsvermögen benötigen, wie sie für Laserdioden mit geradliniger Ausbreitung der Laserstrahlung erforderlich sind.

Aufgabe der vorliegenden Erfindung ist es, einen Betrieb für einen solchen Lichtverstärker, insbesondere eine Ringlaser-Diode anzugeben, der bzw. die sich technologisch einfacher, insbesondere mit höchstens relativ geringem Justieraufwand herstellen und sich vorteilhaft als Multiplexer/Demultiplexer ausgestalten bzw. verwenden läßt. Diese Aufgabe wird mit den Merkmalen des Patentanspruches 1 gelöst und weitere Ausgestaltungen und Weiterbildungen bzw. Verwendungen gehen aus den Unteransprüchen hervor.

Eine Grundlage der vorliegenden Erfindung ist, ein für ringförmige, und zwar verlustlose Strahlungsführung, bisher nicht angewendetes Prinzip einer Phasenführung der optischen Strahlung zu benutzen, das sich insbesondere für eine Ringlaser-Diode eignet.

Sich (wenigstens im wesentlichen) als Parallelstrahl (in isotropem Medium) fortpflanzende optische Strahlung weist ebene Wellenfronten konstanter Phase auf. Diese Wellenfronten sind bei gerader Strahlungsrichtung parallel zueinander ausgerichtet. Läuft jedoch eine solche Strahlung entlang einem Bogen, so stehen die ebenen Wellenfronten weiterhin senkrecht zur Strahlrichtung d.h. senkrecht auf der jeweils an dem Bogen anliegenden Tangente. Dies bedeutet aber, daß die Wellenfronten entlang einem solchen Bogen nicht mehr parallel zueinander ausgerichtet sind. Es liegt somit über den Querschnitt eines solchen gebogenen Strahles hinweg unterschiedliche Phasengeschwindigkeit vor. Die Phasengeschwindigkeit auf der Außenseite des Bogens ist größer als im Zentrum dieses Strahles.

Ist der Brechungsindex des Mediums in dem die Strahlungsausbreitung erfolgt, über den Querschnitt des Strahles bzw. über die jeweilige Ebene hinweg konstant, führt dies dazu, daß die Phasengeschwindigkeit in den äußeren Bereichen des Bogens die für das Medium geltende Phasen-Fortpflanzungsgeschwindigkeit überschreitet und nach außen Energieabstrahlung (analog der klassischen Tscherenkow-Strahlung) auftritt.

Dieser Strahlungsverlust kann vermieden werden, wenn dafür Sorge getragen ist, daß die Phasengeschwindigkeit in auf den Bogen bezogen äußeren Anteilen des Strahlquerschnitts die Phasenfortpflanzungsgeschwindigkeit des Mediums $v_n = v_o/n$ ($v_o$ = Vakuumlichtgeschwindigkeit, n = für die Strahlung örtlich gültiger Brechungsindex im Fortpflanzungsmedium) nicht überschreitet. Zu erreichen ist dies dadurch, daß in den Außenanteilen des Strahlquerschnitts für verringerten Brechungsindex des Mediums gesorgt ist. Für eine Krümmung R des Bogens läßt sich das Auftreten dieser "Tscherenkow-Strahlung" verhindern, wenn man in Richtung des Radius dieser Krümmung eine Abnahme des Brechungsindex entsprechend der Funktion 1:R vorsieht.

3

EP 0 368 925 B1

$$d n(f)/dR = \frac{n_o}{\frac{R_o}{} - R}$$  (1)

Die voranstehende Formel ist der mathematische Ausdruck für einen solchen von Abstrahlung freien Verlauf des Brechungsindex in radialer Richtung des Bogens mit diesem Radius R. In einem (Kreis-)Ringbogen, entlang dem die diesem Ausdruck entsprechende Verteilung des Phasenbrechungsindex vorliegt, wird Licht bzw. Laserstrahlung ohne Auftreten einer Tscherenkow-Strahlung geführt. Für die Art der Wellenführung wird hier der Begriff "Phasenführung" benutzt, wobei es sich neben Indexführung und Gewinnführung um ein drittes Prinzip handelt, das allein oder auch in Verbindung mit Index- und/oder Gewinnführung (bei nichtlinearer Wellenführung) anwendbar ist.

Ist diese 1:R-Bedingung für einen vollständigen Ring erfüllt, so liegt ein insoweit strahlungs-verlustloser Ringresonator vor, der keine Resonatorspiegel benötigt. Die entlang bzw. in einem solchen Kreisring sich fortpflanzende Strahlung ist insich rückgekoppelt, wie dies für andere Ringlaser dem Prinzip nach schon bekannt ist.

Aus der Atomphysik ist für die sogenannte Lorentzlinie die nachstehende Lorentzformel bekannt:

$$n(f) = n_o + \Delta n = n_ó + \frac{g \cdot (R) \cdot \lambda}{4 \pi \cdot (1 + I/I_o)} \cdot \frac{(f-f_o)/(\Delta f/2)}{1 + (f-f_o)^2/(\Delta f/2)^2}$$  (2)

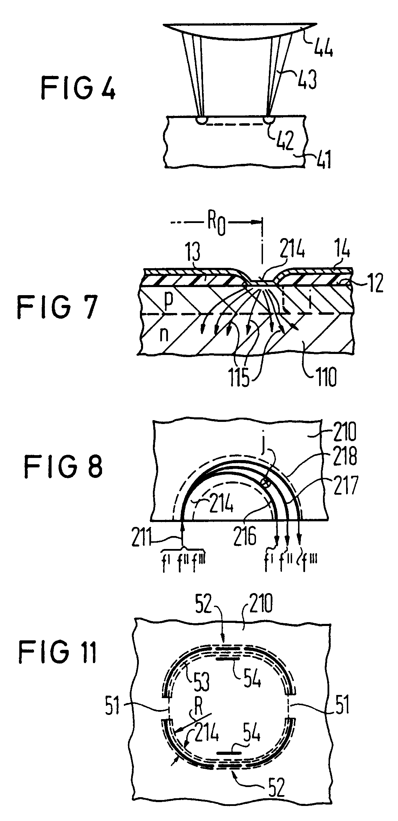

die aussagt, daß spektrale Emission oder Absorption bzw. optisches Resonanzverhalten eines Materials begleitet ist von einer entsprechenden spektralen Brechungsindex-Änderung $n_o \pm \Delta n$ dieses Materials. Figur 4 in J. Appl. Phys. Bd. 52 (1981) S. 4457-61 (4459) zeigt eine derartige Änderung

In der Formel (2) sind:

$f_o$ die Resonanz- bzw. Mittenfrequenz der (Resonanz-)linie

$n_o$ der Wert des von diesem Resonanzeffekt nicht beeinflußten (dispersiven) Brechungsindexes, der im übrigen auch für die Frequenz $f_o$ gilt,

f cie Frequenz, für die der Wert $n_o + \Delta n$ gilt, ( n kann auch negativ sein),

$\Delta f$ die Halbwerts-(Band-)breite der Linie ,

$I/I_o$ ein Intensitätsverhältnis, beim Laser das Verhältnis der vorhandenen Strahlungsintensität zur Sättigungsintensität,

$\lambda$ die Wellenlänge z.B. der erzeugten Laserstrahlung

go das Verstärkungs- (oder Absorptions-)Maß für die Mittenfrequenz.

Die obengenannten wissenschaftlichen Erkenntnisse liegen der nachfolgenden Lehre zum technischen Handeln zugrunde.

Das Verstärkungs- (oder Absorptions-)Maß g ist innerhalb der Linie frequenzabhängig und bei einem Laser mit örtlich (x,y) nicht-konstantem Pumpen (z.B. mit örtlich verschiedener Stromdichte der Ladungsträgerinjektion) ortabhängig.

Für einen wie nachfolgend beschriebenen Ring-Wellenleiter bzw. -Laser mit dem jeweiligen mittleren Ringradius $R_o$, sind Orte außerhalb dieses Ringes mit $(R_o + \Delta R)$ und Orte innerhalb des Ringes mit $(R_o - \Delta R)$ bezeichnet. Der Ort $R_o$ entspricht dem Zentrum oder Maximum der Ladungsträgerinjektion bzw. des optischen Pumpens.

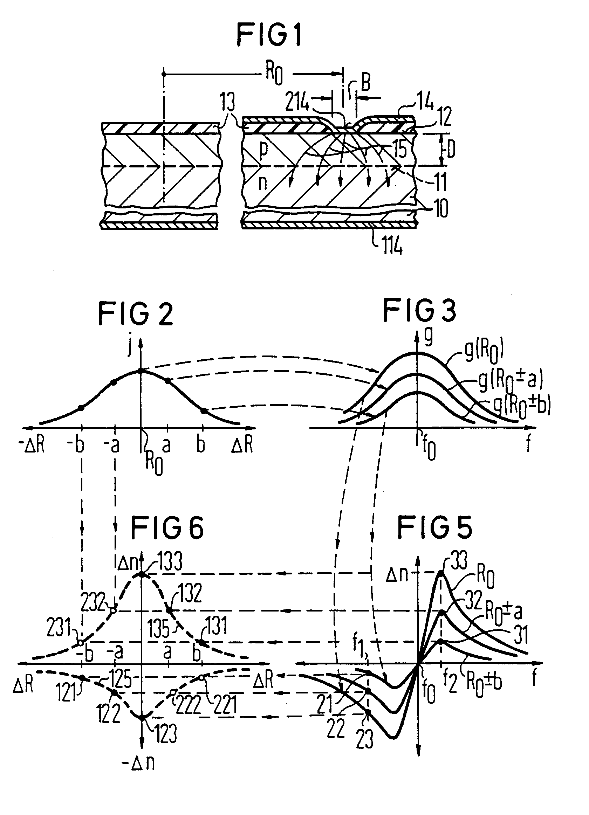

Die Figur 1 zeigt die Schnittdarstellung eines Ringlasers mit einem Halbleiterkörper 10 mit einem pn-Übergang 11. Auf der Oberfläche 12 dieses Halbleiterkörpers ist eine Isolationsschicht 13 aus z.B. Siliziumdioxid vorgesehen. Der Pfeil R gibt mit $R_o$ den Radius der ringförmigen Bahn dieses Ringlasers an. Mit 14 ist eine Elektrode und mit 114 eine Gegenelektrode auf der der Oberfläche 12 gegenüberliegenden Oberfläche des Halbleiterkörpers 10 bezeichnet. Am Ort des Radius $R_o$ liegt die Elektrode 14 als Ringstreifen 214 mit relativ geringer Breite B auf der Oberfläche 12 des Halbleiterkörpers 10 auf. Im Bereich des Ringstreifens 214 ist elektrischer Kontakt mit dem Material des Halbleiterkörpers 10 vorhanden. Es liegt dort ein wenigstens weitgehend ohm'scher, möglichst niederohmiger Metall-Halbleiterkontakt vor. Die Ausbildung eines solchen nur in einem vorgegebenen Bereich auf der Oberfläche eines Halbleitermaterials aufliegenden, seitlich davon jedoch durch die Isolationsschicht 13 isolierten Metallkontaktes ist für gewinngeführte Laserdioden gut bekannt. Statt einer elektrischen Isolation durch die Isolationsschicht 13 kann auch vorgesehen sein, daß in diesem Bereich außerhalb des Ringstreifens 214 der Metall-Halbleiter-

4

EP 0 368 925 B1

kontakt die Eigenschaft eines möglichst weitgehend sperrenden Schottky-Kontakts hat. Eine derartige Ausführung ist z.B. als MCRW-Laserdiode bekannt.

Hinsichtlich der Details des Aufbaues des Halbleiterkörpers 10 sei auf das Bekannte hingewiesen. Vorteilhafterweise ist ein Doppelheteroschicht-Aufbau vorgesehen, der außerdem auch indexführende Schichten besitzt, die sich parallel zur Ebene des pn-Überganges 11 oberhalb und unterhalb benachbart desselben erstrecken. Diese können in Richtung senkrecht zu diesen Ebenen (senkrecht zu R) Wellenführung bewirken.

Die in Figur 1 durch die gekrümmten Pfeile angedeutete Stromverteilung bzw. -Aufweitung im Halbleiterkörper 10 ist in der Figur 2 grafisch dargestellt. Mit 15 ist das Stromverteilungsprofil j (± Δ R) dargestellt, und zwar wie es sich im Bereich des entscheidenden pn-Überganges 11 des Halbleiterkörpers 10 bei einem Abstand D zwischen diesem Übergang 11 und dem Ringstreifen 214 ergibt, wobei relativ bzw. möglichst geringe Breite B für diesen ringförmigen Streifen 214 vorgesehen ist. Die Gegenelektrode 114 ist diejenige der Figur 1. Ersichtlich hängt das Profil j (± Δ R) von den Größen D und B ab. Zweckmäßig sind Werte zwischen 1 und 10 $\mu$m für B und Werte zwischen 1 und 10 $\mu$m für die Tiefe D.

Bekanntermaßen ist die Verstärkung einer mit elektrischem Strom gepumpten Laserdiode abhängig von der jeweiligen Stromdichte. Im Bereich des Ringes $R_o$ ist wenigstens im Regelfall die höchste Verstärkung $g_o$ festzustellen, und zwar für die Frequenz $f_o$, die der Mittenfrequenz des optischen Resonators entspricht.

Figur 3 zeigt in einer grafischen Darstellung, aufgetragen über der Frequenz, das Maß der Verstärkung g. Die mit g ($R_o$) gekennzeichnete Kurve gibt die auf dem Ring mit $R_o$ vorliegende Verstärkung g an, die,wie dargestellt, abseits der Mittenfrequenz $f_o$ zu kleineren und zu größeren Frequenzen f hin abfällt. In der Figur 3 sind außerdem auch die entsprechenden Kurven für außerhalb des Ringes $R_o$ liegende Ringbahnen dargestellt, und zwar für Radien ($R_o$ ± a) und für ($R_o$ ± b). In Figur 2 sind die abweichenden Durchmesser mit R = ± a bzw. = ± b kenntlich gemacht. Auf den Ringen $R_o$ ± a und $R_o$ ± b ist die strominjizierte Anregung der Stromverteilung der Fig. 1 entsprechend jeweils kleiner.

Es sei hier darauf hingewiesen, daß sich für einen optisch gepumpten Ringlaser eine ähnliche Verteilung g(f, R) ergibt. Hierfür wählt man für einen Ringstreifenbereich eine entsprechende, vom Radius R abhängige Intensitätsverteilung des eingestrahlten pumpenden Lichts.

Fig. 4 zeigt mit 41 bezeichnet einen Körper aus laseraktivem Material, wie z.B. NdAl$_3$ (BO$_3$)$_4$. Mit 42 ist eine ringförmige Bahn für die Laserstrahlung in diesem Körper 41 bezeichnet. Das optische Pumpen erfolgt im Bereich dieser Bahn 42 durch entsprechend ringförmige Bestrahlung mit fokussiertem Pumplicht 43. Mit 44 ist eine Fokussierungslinse bezeichnet.

Figur 5 zeigt in grafischer Darstellung die Abhängigkeit der sich für den Parameter g(R) nach Figur 3 ergebenden Brechungsindexänderung, und zwar von der Frequenz erzeugter Laserstrahlung. Entsprechend den Parameterwerten g($R_o$), g($R_o$ ± a) und g($R_o$ ± b) erhält man die in der Figur 5 wiedergegebenen Kurven. Diese Kurven verlaufen bei der Frequenz $f_o$ durch den Wert Δ n = 0. Außerhalb dieses Nullpunktes gibt es Minima und Maxima aufweisende Verläufe mit höchsten Werten für Δ n für den Ring mit dem Durchmesser $R_o$. In Figur 5 sind zwei Frequenzwerte $f_1$ und $f_2$ hervorgehoben.

Aus Figur 5 läßt sich die grafische Darstellung der Figur 6 ableiten, die wiederum die Brechungsindexänderung Δ n angibt, dort aber in Abhängigkeit des Maßes Δ R bezogen auf den Ringdurchmesser $R_o$. Aus der Grafik der Figur 5 läßt sich der mit 21 bezeichnete Wert Δ n für die Frequenz $f_1$ und den Verstärkungsgrad g auf der Kreisbahn $R_o$ ± b in die Darstellung der Figur 6 übertragen. Es ergeben sich für die Durchmesser $R_o$ - b und $R_o$ + b die beiden Werte 121 und 221, nämlich mit dem Wert - Δ n aus Figur 5. In entsprechender Weise erhält man für diese Frequenz $f_1$ und den Parameter g ($R_o$ ± a), ausgehend vom Wert 22 in Figur 5 in der Figur 6 die Werte 122 und 222. Der entsprechende Wert 23 für die Frequenz $f_1$ des Parameters g($R_o$) geht in Figur 6 in den Wert 123 über, der für die Frequenz $f_1$ das Maximum der (negativer) Brechungsindexänderung Δ n ist.

Sinngemäß erhält man in der Darstellung der Figur 6 die Werte 131, 231 für die Frequenz $f_2$ und die Parameterwerte g ($R_o$ ± b).

Entsprechendes gilt für die Übertragung der Werte 32 und 33 aus der Figur 5 in die entsprechenden Werte 132 und 232, sowie den Wert 133 in Figur 6.

Wie aus Figur 6 ersichtlich ist, ergibt sich für eine Laserfrequenz $f_1$ eine radiusabhängige Brechungsindexänderung, die dem Verlauf 121, 122, 123 im dritten Quadranten entspricht. Dieser Verlauf 125 gibt an, daß für die Frequenz $f_1$ kleiner als $f_o$ der Brechungsindex n unterhalb des Wertes $R_o$ mit größerwerdendem Durchmesser R kleiner wird. Für die Frequenz $f_2$ größer als $f_o$ zeigt der Verlauf 135 im ersten Quadranten, daß für zunehmenden Radius R oberhalb des Wertes $R_o$ ebenfalls abnehmendes Verhalten für den Brechungsindex n vorliegt. Dieses Verhalten ist die oben bereits erörterte Notwendigkeit (Gl. 1) für phasengeführten Umlauf von Laserstrahlung eine solche ringförmige Bahn zu haben, bei der über den endliche Abmessung aufweisenden Querschnitt des Ringes hinweg von Tscherenkow-Strahlung freie

5

Fortpflanzung der Strahlung auftritt. Wie aus den Figuren 2, 3 und 5 ersichtlich, läßt sich eine in Figur 6 dargestellte Abhängigkeit $\Delta$ n ($\Delta$ R) erzielen, die in den Quadranten 3 und 1 eine wenigstens weitgehend angenäherte Abhängigkeit des Brechungsindexverlaufs entsprechend -1/R erreicher läßt, nämlich der die oben angegebene Gleichung (1) erfüllt.

Für die Berechnung der Frequenzabstimmung für einen erfindungsgemäßen Ringlaser mit einem, nämlich durch die Ausbildung der Elektrode 14 nach Figur 1 vorgegebenem Krümmungsradius R, steht die Gleichung (3) zur Verfügung.

$$ R = \frac{-n}{dn/dR} = - \frac{4\pi\eta\left(1 + \frac{I}{I_0}\right)}{\lambda\,(dg/dR)} \cdot \frac{1+\varphi^2}{\varphi} \qquad (3) $$

Für die Anwendbarkeit dieser Gleichung ist vorausgesetzt, daß das Intensitätsverhältnis $I/I_0$ (siehe Gleichung (2)) sehr klein ist, d.h. der Betrieb bei einer Strahlungsintensität wesentlich unterhalb des Wertes der Sättigungsintensität $I_0$ erfolgt.

Die Größe $\phi$ ist die in der Maßeinheit $\Delta$ f/2 ausgedrückte Frequenzverschiebung der Frequenz f gegenüber der Frequenz $f_0$.Es gilt

f = $f_0$ + $\phi$ ($\Delta$ f/2).

Weiter gilt entsprechend den obigen Ausführungen

dg/dR = G .$\bar{j}$.

Die Größe $\phi$ gibt an, wie weit die tatsächliche Frequenz f von der Mittenfrequenz $f_0$ der Laserdiode entfernt liegt. Der Faktor G ist ein Geometriefaktor, der vom Abstand D des pn-Übergangs von der Oberfläche 12 des Halbleiterkörpers 10, von der Breite B des auf der Halbleiteroberfläche 12 aufliegenden Ringstreifens 214 der Elektrode 14 und von der Leitfähigkeit des Halbleitermaterials abhängt. Es wurde erkannt, daß der Faktor G vorteilhafterweise fast konstant (unabhängig von R oder leicht fokussierend) ist und dies mit der Gleichung

G = $G_0$ - $\beta$ . R

mit $\beta$ größer 0
auszudrücken ist. Die Größe G läßt sich auch in der Weise beeinflussen, daß angepaßte Stromdichteverteilung 115 durch inhomogene Leitfähigkeitsverteilung im Halbleiterkörper erzeugt ist, wie dies anhand der Figur 7 bildlich erläutert ist. Der mit i bezeichnete Halbleiterbereich des Halbleiterkörpers 110 in Figur 7 ist hochohmig gemacht. Es ist bei dieser Ausführungsform das erfindungsgemäße Erzeugen von ringförmig umlaufender Laserstrahlung auf den Bereich -$\Delta$ R beschränkt.

Die Größe $\bar{j}$ ist die mittlere Stromdichte, die proportional dem gesamten Injektionsstrom ist. Aus der Gleichung

$$ A \qquad \frac{dR}{R} = \frac{dR \cdot \delta f}{df \cdot R} + \frac{dR \cdot \delta \bar{j}}{d\bar{j} \cdot R} = 0 $$

folgt die Gleichung

$$ B \qquad \frac{df}{\Delta f/2} = \varphi\,\frac{\varphi^2+1}{\varphi^2-1} \cdot \frac{\delta \bar{j}}{\bar{j}} = \eta\,\frac{\delta \bar{j}}{\bar{j}} $$

Für die Größen $\gamma$ und $\eta$ lassen sich die nachfolgenden Wertepaare angeben

$$
\begin{array}{c|c|c|c|c|c|c|c|c}
-\infty & -2 & -1 & -1/2 & 0 & 1/2 & 1 & 2 & \infty \\
-\infty & -10/3 & -\infty & 5/6 & 0 & -5/6 & \infty & 10/3. & \infty
\end{array}
$$

Aus diesen Wertepaaren ist, wie nach Kenntnis von der Erfindung ersichtlich, für $f = f_o$, d.h. für = 0 keine Frequenzveränderung zu erreichen, nämlich weil, wie aus den Figuren 2, 3, 5 und 6 ersichtlich für $f_o$ der Wert $\Delta$ n = 0 ist. Jedoch bei einem Wert $f = f_o \pm \Delta$ f/2, d.h. bei $\phi = \pm 1$) ergeben sich die minimalen Radien. Ersichtlich resultiert daraus eine große Empfindlichkeit bzw. ein großer Bereich der Abstimmbarkeit.

Im Bereich der Extremwerte von n(f) liegt der Wert $\eta$ ungefähr bei 1, d.h. $\delta$ f/$\Delta$ f/2 ist angenähert gleich $\delta$ $\bar{j}/\bar{j}$. Daraus ist zu ersehen, daß die Größe der Frequenzänderung ungefähr gleich dem Produkt aus der halben Bandbreite ($\Delta$ f/2) und der relativen Stromänderung ist. Dies gibt dem Fachmann die von ihm anzuwendenden Abstimmungsmöglichkeiten an.

Nachfolgend soll die Lehre der Erfindung und ihre Benutzung an einem Beispiel noch ergänzend erläutert werden.

Die Bandbreiten eines erfindungsgemäßen Ringlasers liegen bei einigen 100 $cm^{-1}$. Für eine (halbe) Bandbreite von z.B. $\Delta$ f/2 etwa gleich 2 THz und eine Bandbreite von 20 GHz eines Übertragungskanals im GHz-Bereich (z.B. 2,4 Gb/s) läßt sich die Bandbreite eines solchen Übertragungskanals mit 1°/oo Änderung des Injektionsstroms ganz durchstimmen. Bei dieser Durchstimmung bleibt der Krümmungsradius dieses Ringlasers entsprechend dem ringförmigen Kontakt 214 der Laserdiode fest vorgegeben. Bei dem vorgenannten Beispiel bleibt also der Radius fest beibehalten und mit Hilfe der Änderung der Größe des Injektionsstromes läßt sich die Frequenz der erzeugten Laserstrahlung im entsprechend angegebenem Bereich verändern.

Umgekehrt läßt sich bei konstant gehaltenem Injektionsstrom erreichen, daß in eine erfindungsgemäße Anordnung eingestrahlte Strahlung je nach (innerhalb der entsprechenden Bandbreite liegender) unterschiedlicher Frequenz auf unterschiedlich großen (Kreis-)Bögen im Halbleitermaterial verläuft. Fig. 8 zeigt, wie an einer Stelle des Halbleiterkörpers 210 in der Richtung 211 eingestrahlte Strahlung je nach deren Frequenz in unterschiedlich großen Bögen 216, 217, 218 in dem durch Strominjektion gepumpten Halbleitermaterial 210 verläuft und an frequenzabhängig verschiedenen Stellen dieses Halbleiterkörpers wieder austritt. Es ist auf diese Weise eine räumliche Trennung der Strahlung verschiedener Kanäle möglich. Zum Beispiel läßt sich bei einer Frequenzmultiplexübertragung mit 1% Abstand der einzelnen Kanäle voneinander eine Auffächerung der Kreisbögen der Strahlungsverläufe im Halbleitermaterial erreichen, die um jeweils 1% unterschiedliche Krümmungsradius von Kanal zu Kanal aufweist. Die räumliche Trennung von Kanal zu Kanal entspricht dann einem jeweiligen Abstand von 0,02 . R.

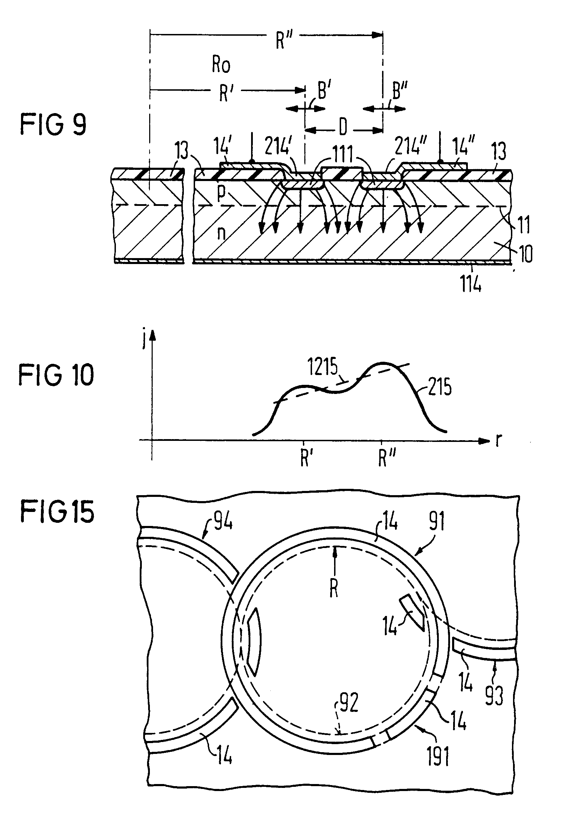

Fig. 9 zeigt eine Alternative bzw. weitere Ausgestaltung einer Ausführungsart der Erfindung, mit der der aktive Durchmesser des Laserstrahlung-erzeugenden Ringes bzw. der Ort der rings bzw. wenigstens bogenförmigen Laserstrahlungs-Erzeugung einstellbar ist.

In Fig. 9 sind mit 14 und 14'' zwei koaxial zueinander angeordnete ringförmige Elektroden bezeichnet. Es können dies auch bogenförmige (Sektor-)Ausschnitte solcher konzentrischer Ringe sein. Einzeln entsprechen sie der Elektrode 14 der Fig. 1. Sie haben mit den Ringstreifen 216' bzw. 214'' mit Breitenabmessungen B' und B'' elektrischen Kontakt mit der Oberfläche 12 des Halbleiterkörpers 10. D ist der Abstand beider Ringstreifen voneinander. Mit 13 ist eine (ringförmig mehrmals unterbrochene) Isolationsschicht 13, wie in Fig. 1 vorhanden, bezeichnet. Mit 111 sind hier zusätzlich vorgesehene ($p^+$) Kontaktbereiche bezeichnet, die im Halbleitermaterial für guten ohm'schen Kontakt mit den Elektroden 14', 14'' in den Streifenbereichen 214', 214'' sorgen.

Die Elektroden 14' und 14'' lassen sich voneinander getrennt mit elektrischen Strom speisen. Durch das Verhältnis der Ströme (Stromdichten j' und j'') zueinander läßt sich abhängig von B', B'' und D als Parameter eine resultierende Stromdichteverteilung 215 in der Ebene des pn-Überganges 11 dieser "Doppelringstruktur" 14', 14'' erreichen. Derartiges zeigt die Figur 10. Die gestrichelte Linie 1215 ist eine (für den relevanten Durchmesserbereich gültige lineare Annäherung an die Strom(dichte-)verteilung 215. Daraus ergibt sich eine steuerbare 1/R Abnahme des Brechungsindex, nämlich wie sie zur Realisierung der Erfindung erforderlich ist. Es läßt sich damit (unter Berücksichtigung der weiteren Parameter) eine passende Ringgröße $R_o$ einstellen bzw. vorgeben. Mittels Einstellung der Werte der Ströme läßt sich die Verstärkung beeinflussen.

Eine dem voranstehenden Prinzip entsprechende Ausführungsform der Erfindung kann auch mehr als zwei derartig koaxial angeordnete Elektroden bzw. bogenförmige Abschnitte solcher Elektroden haben.

EP 0 368 925 B1

Entsprechende Ausführungsformen lassen sich auch für optisches Pumpen verwenden. An die Stelle der Elektroden 14', 14'' treten dort im wesentlichen form- und ggfs. auch flächengleiche Oberflächenbereiche der Oberfläche des laseraktiven Materials in denen dieses Material mit der Pumpstrahlung beaufschlagt sind. An die Stelle der Ströme bzw. Stromdichten tritt dann dort die steuerbar einzustellenden Bestrahlungs-Intensitäten der ring- bzw. togenförmigen Bereiche.

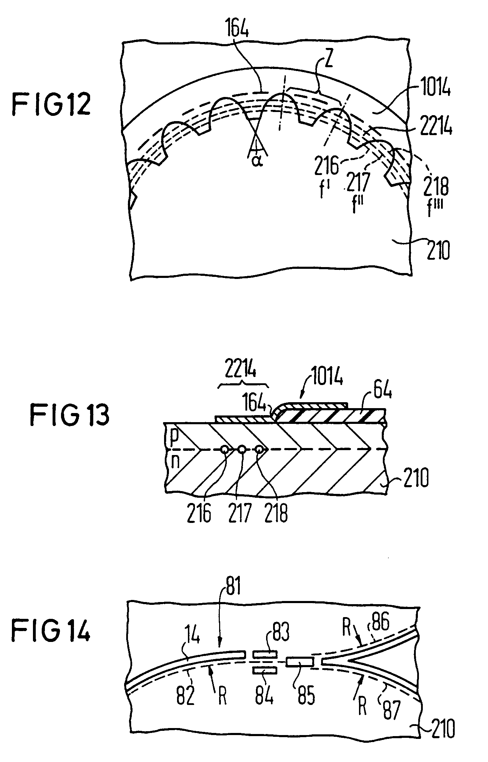

Zusätzlich zum erfindungsgemäßen Tscherenkow-strahlungsfreien bogenförmigen Verlauf einer Strahlung, z.B. im gepumpten Halbleitermaterial können in den Strahlungsverlauf auch noch defokussierende und damit verbunden absorbierende Abschnitte 51 und oder fokussierende und damit verbunden verstärkende Elemente 52 als Anteile eines gesamten Umlaufringes in diesen eingefügt sein. Fig. 11 zeigt einen solchen Umlaufring mit den eingefügten zwei Abschnitten 51 und zwei Elementen 52. Die Bahn 53 des Strahlungsumlaufes ist in der Fig. 11 gestrichelt dargestellt. Den Elementen 52 ist jeweils eine Modulationselektrode 54 hinzugefügt, die ein Elektrodenstreifen auf der Oberfläche des Halbleitermaterials ist. In dem Bereich eines Elementes 52 ist diese Elektrode 54 neben der ringförmigen Elektrode 14 bzw. ihrem Kontaktstreifen 214 angeordnet. Wie ersichtlich hat der defokussierende, dämpfende Abschnitt keinen Anteil der ansonsten ringförmig geschlossenen Injektionselektrode 14.

Durch modulierte Strominjektion mit Hilfe der Elektrode 54 läßt sich die umlaufende Strahlung intensitäts-modulieren.

Die Fig. 12 und 13 zeigen eine weitere Ausgestaltung zu einer der in Fig. 8 entsprechenden Anwendung der Erfindung. Die Größe der bei einer Anordnung nach Fig. 8 vorliegenden Auffächerung, im Bereich der frequenzselektiven räumlichen Trennung der Strahlung der einzelnen Kanäle hat eine Begrenzung in dem Umstand, daß die Breite des auf der Halbleiteroberfläche kontaktierenden Elektrodenstreifens 214 nicht beliebig groß sein kann, da andernfalls der erfindungsgemäß beeinflußte Brechungsindex keinen für die Erfindung noch ausreichenden 1/R-Abfall im Bereich des pn-Überganges hätte. Abschätzungsweise liegt die noch zulässige Breite des kontaktierenden ringförmigen Bereiches 214 zwischen dem Maß D und D/2, worin D der in Fig. 1 angegebene Abstand des pn-Übergangs von der kontaktierten Halbleiteroberfläche 12 ist. Eine weitere Ausgestaltung besteht darin, daß der kontaktierende Bereich 214 eine wie aus der Fig. 12 hervorgehende, auf der Bogeninnenseite gezackte bzw. gezahnte Form erhält. Mit 216 bis 218 sind bogenförmige Verläufe entsprechend denen der Fig. 8 bezeichnet. Mit R ist der Radius des Bogens angegeben, worin R die oben angegebene Bedeutung hat. Die "Zahnteilung Z" und die weiteren Abmessungen werden zur Erzielung besonders günstigen Effektes wenigstens angenähert nach der Gleichung bemessen:

$$R = \frac{n \cdot Z}{2 \cdot n \cdot tg\,\alpha/2}$$

Für ein Zahlenbeispiel mit dem Brechungsindex n = 2 des Halbleitermaterials, Z = 10 $\mu$m, mit n = 0,02 und dem Winkel $\alpha$ = 90° ergibt sich z.B. ein Bogendurchmesser R = 500 $\mu$m.

Zur ergänzenden Erläuterung dient die Fig. 13, die einen Querschnitt durch die Konfiguration nach Fig. 12 angibt. Mit 64 ist eine Schicht aus elektrisch-isolierendem Material bezeichnet. Es ist zu entnehmen, daß der Elektrodenstreifen 1014 vorzugsweise nur mit den zahnförmigen Anteilen 2214 auf der Oberfläche des Halbleitermaterials des Halbleiterkörpers 210 aufliegt.

Strenggenommen verlaufen die Strahlungswege 216, 217, 218 nicht exakt bogenförmig, sondern zwischen den Zähnen 2214 liegen im wesentlichen gradlinige Abschnitte vor. Dementsprechend liegt von einem Zahn zum benachbarten Zahn ein Ablenkwinkel der Strahlung vor, wobei dieser Winkel

$\Sigma$ = 2 ($\Delta$ n/n) . tg $\alpha$ /2,

kleiner als 0,04 tg $\alpha$ /2 ist.

Eine weitere Ausgestaltung dieser Ausführungsform zu einer Anwendung der Erfindung besteht darin, den Flanken der Zähne 2214 eine leichte Krümmung zu geben, womit sich eine vorteilhafte Lichtfokussierung erreichen läßt.

Zu dem obengenannten Zahlenbeispiel sei noch angemerkt, daß wegen des Elektronendichte-Effekts, der zu den Werten n führt, diese Ausführungsform einer Anwendung der Erfindung auch für einen solchen Halbleiterlaser verwendbar ist, bei dem die Strahlung in Linienmitte läuft.

Die Fig. 14 zeigt eine auf der Anwendung der Erfindung beruhende Ausgestaltung einer Weiche für den Strahlungsverlauf. Mit 81 ist ein Bogenstück bezeichnet, zu dem eine streifenförmige Elektrode 214 gehört,

8

wie sie in der Fig. 1 beschrieben ist. Mit R ist der Radius der Bahn 82 eines erfindungsgemäßen Strahlungsverlaufs bezeichnet. Mit 83 und 84 sind Elektrodenabschnitte bezeichnet, die, wie aus der Fig. 14 ersichtlich, nebeneinanderliegend beiderseits der Bahn 82 angeordnet sind. Durch Aufteilung der Strominjektion auf die Elektrodenabschnitte 83 und 84 läßt sich eine steuerbare Beeinflussung der Lage der Bahn 82 zwischen diesen beiden Elektrodenabschnitten 83 und 84 erreichen. Mit 85 ist eine Hilfselektrode bezeichnet. Mit Hilfe der Elektroden 83, 84 und 85 läßt sich eine steuerbare Verlagerung der Bahn 82 in den jeweiligen weiteren Bahnabschnitt 86 oder 87 erreichen. Diese Bahnen 86 und 87 haben z.B. wieder dieselbe Krümmung R, jedoch weisen die Krümmungsradien der Bahnen 86 und 87 in zueinander verschiedene Richtungen. Auf den Bahnen 86 und 87 verläuft die Strahlung in erfindungsgemäßer Weise. Der Radius R beträgt z.B. 150 $\mu$m, die Länge der Elektrode 85 10 $\mu$m bei etwa 2 $\mu$m Breite. Die Elektrodenabschnitte 83 und 84 haben etwa gleichgroße Bemessung wie die Elektrode 85 und ihr Abstand voneinander beträgt etwa 12 $\mu$m.

Fig. 15 zeigt eine Anwendung der Erfindung und darin Ausführungen zu Ein- und Auskopplungen von erfindungsgemäß erzeugter Strahlung. Die Fig. 15 zeigt eine Aufsicht auf einen Halbleiterkörper mit einer ringförmigen Elektrode 14, die wie zur Fig. 1 im einzelnen ausgeführt ist. Der ganze Ring dieses einen Ringlasers in der Ausführungsform nach Fig. 15 ist mit 91 bezeichnet. Dieser Ring 91 enthält einen Abschnitt 191, mit dessen Hilfe durch Steuerung der Strominjektion eine Steuerung bzw. modulartigen der Strahlungsverstärkung im Ring 91 bewirkt werden kann. Mit 92 ist die zugehörige Bahn der erfindungsgemäß phasengeführt umlaufenden Strahlung bezeichnet.

Mit 93 und 94 sind Abschnitte von Ein- bzw. Auskoppelbahnen bezeichnet. Diese schneiden den Ring 91 mit ein- bzw. auskoppelnder Wirkung, wie dies für Laserdiodenanordnungen mit gradliniger Strahlungsausbreitung schon bekannt ist. Durch Modulation der Strominjektion für die Bahnen 93 und/oder 94 kann eine Steuerung bzw. Modulation der Ein- und/oder Auskopplung durchgeführt werden.

Für Multiplexbetrieb können mehrere ringförmige Bahnen 91, 94 ... auf einem solchen Halbleiterkörper vorgesehen sein. Für jeden einzelnen Ring kann die Frequenz der in dem jeweiligen Ring erzeugten Laserstrahlung mit dem jeweiligen Injektionsstrom feinabgestimmt werden.

Solche Bahnenstücke 93, 94, und/oder der Ring 91 bzw. dessen Ringanteil 191 können auch als Sender- oder Detektorsegmente für die im Ring der Laserdiode erzeugte Laserstrahlung dienen.

Eine erfindungsgemäße Ringlaser-Diode eignet sich aufgrund ihres Halbleiteraufbaus zur Integration mit IC-Schaltungen, die der zugeordneten Signalverarbeitung dienen.

Bei allen Ausführungsformen und Anwendungsbeispielen mit erfindungsgemäßer Phasenführung der Strahlung kann zusätzlich auch noch Indexführung durch vorgesehene Schichtfolgen nach Art des Doppelheteroschichtbaues, wie für Laserdioden gut bekannt, vorgesehen sein.

## Patentansprüche

1. Verfahren zum Betrieb eines Lichtverstärkers mit bogen- bzw. ringförmig geführter Strahlungsbahn im laseraktiven Material des Lichtverstärkers, mit einer Breite (B) der auf der Oberfläche des laseraktiven Materials vorgesehenen bogen- bzw. ringförmigen Pumpzone, die in einer Tiefe (D) des laseraktiven Materials ihre Pumpwirkung entfaltet,
   wobei ein Verteilungsprofil (15) dieser Pumpwirkung, bezogen auf die Strahlungsbahn ($R_0$), vorliegt und der Gradient (Fig. 2) des Profils der Pumpwirkung einen davon abhängigen Gradienten des Brechungsindex (n) des laseraktiven Materials bewirkt und das Verstärkungsmaximum ($g_{max}$) bei der Strahlungsfrequenz $f_0$ liegt (Fig. 3)
   **gekennzeichnet dadurch,**
   daß phasengeführte Strahlung einer Frequenz $f_{1;2} = f_0 \mp \Delta f$ (Fig. 5) bei einer Verstärkung $g(f_{1,2})$, die kleiner als die maximale Verstärkung $g_{max}$ (Fig. 3) ist bei Abstimmung der Breite (B) und der Tiefe (D) erzeugt wird,
   wobei man diese Strahlung der Frequenz $f_{1,2}$ in einem sich für diese Strahlungsfrequenz einstellenden solchen Radiusbereich $R = R_0 \mp \Delta R$ umlaufen läßt, in dem der durch die Pumpwirkung (Fig. 2) veränderte Brechungsindex $n(R) = n_0 \mp \Delta n$ (Fig. 6) einen (- 1/R) wenigstens angenäherten Brechungsindexverlauf hat, wobei auf dieser Strahlungsbahn das Auftreten von Strahlung analog zu Tscherenkow-Strahlung vermieden ist.

2. Verfahren zum Betrieb eines Lichtverstärkers nach Anspruch 1, bei dem optisches Pumpen in laseraktivem Material entlang einem bogenförmigen Bestrahlungsstreifen durchgeführt wird.

3. Verfahren zum Betrieb eines Lichtverstärkers nach Anspruch 2, mit zwei koaxial plazierten ring- bzw.

wengistens bogen-förmigen Bestrahlungsbereichen der Oberfläche des laseraktiven Materials.

**4.** Verfahren zum Betrieb eines Lichtverstärkers nach Anspruch 1, bei dem Strominjektion (j) in Halbleitermaterial (10) entlang einem als Elektrode (214) ausgebildeten streifen vorgesehen wird, wobei das Pumpniveau durch den Injektionsstrom (j) bemessen bzw. gesteuert wird.

**5.** Verfahren zum Betrieb nach Anspruch 1,2 oder 3,
mit kreis- bzw. kreisbogenförmiger Strahlungsbahn, d.h.R = örtlich konstant.

**6.** Verfahren zum Betrieb eines Lichtverstärkers nach einem der Ansprüche 4 oder 5,
mit zwei koaxial angeordneten ring- bzw. wenigstens bogenförmigen Elektroden (14 ,14'') mit denen separate Stromspeisung (Fig. 9, 10) durchgeführt wird.

**7.** Verfahren zum Betrieb nach Anspruch 4 oder einem der weiteren Ansprüche, wobei der Lichtverstärker mit einer gezahnten Injektionselektrode (1014,2214, Fig. 10) versehen ist.

**8.** Verfahren zum Betrieb nach Anspruch 4 oder einem der weiteren Ansprüche, wobei der Lichtverstärker in einem integrierten Halbleiteraufbau eine Steuerungs-, Modulations-, und/oder Auswerteelektronik umfaßt.

**9.** Verfahren zum Betrieb eines Lichtverstärkers nach Anspruch 1 bis 8, als Multiplexer und/oder Demultiplexer (Fig. 8, 9, 12, 1).

**10.** Verwendung des Verfahrens zum Betrieb eines Lichtverstärkers nach einem der Ansprüche 1 bis 8, zur Steuerung der und/oder als Weiche für die Bahnrichtung (Fig. 8, 9, 12, 14).

## Claims

**1.** Method for the operation of a light amplifier having an arcuately or annularly guided radiation path in the laser-active material of the light amplifier, having a width (B) of the arcuate or annular pump zone provided on the surface of the laser-active material, which pump zone develops its pump action in a depth (D) of the laser-active material, a distribution profile (15) of this pump action existing with reference to the radiation path ($R_0$), and the gradient (Fig. 2) of the profile of the pump action effecting a gradient of the refractive index (n) of the laser-active material dependent thereon, and the gain maximum ($g_{max}$) being located at the radiation frequency $f_0$ (Figure 3), characterised in that phase-guided radiation of a frequency $f_{1,2} = f_0 \pm \Delta f$ (Figure 5) is generated given a gain $g(f_{1,2})$ that is smaller than the maximum gain $g_{max}$ (Figure 3) and given of the width (B) and the depth (D), this radiation of frequency $f_{1,2}$ being allowed to circulate in a radius region $R = R_0 \pm \Delta R$, established for this radiation frequency, in which the refractive index n (R) - $n_0 \pm \Delta n$ (Fig. 6) modified by the pump action (Fig. 2) has a refractive index curve at least approaching (- 1/R), the occurrence of radiation analogous to Cherenkov radiation being avoided on this radiation path.

**2.** Method for the operation of a light amplifier according to Claim 1, in which optical pumping in the laser-active material is carried out along an arcuate irradiation strip.

**3.** Method for the operation of a light amplifier according to Claim 2, comprising two coaxially placed annular or at least arcuate irradiation regions of the surface of the laser-active material.

**4.** Method for the operation of a light amplifier according to Claim 1, in which current injection (j) into semiconductor material (10) is provided along a strip fashioned as an electrode (214), the pump level being dimensioned or controlled by the injection current (j).

**5.** Method for the operation of a light amplifier according to Claim 1, 2 or 3, comprising a circular or arcuate radiation path, that is to say R = spatially constant.

**6.** Method for the operation of a light amplifier according to one of Claims 4 or 5, comprising two coaxially arranged annular or at least arcuate electrodes (14', 14''), by means of which a separate current supply (Figs. 9, 10) is carried out.

**7.** Method for the operation of a light amplifier according to Claim 4 or one of the further claims, the light amplifier being provided with a toothed injection electrode (1014, 2214, Fig. 10).

**8.** Method for the operation of a light amplifier according to Claim 4 or one of the further claims, the light amplifier comprising control, modulation and/or evaluation electronics in an integrated semiconductor structure.

**9.** Method for the operation of a light amplifier according to Claims 1 to 8 as multiplexer and/or demultiplexer (Figs. 8, 9, 12, 1).

**10.** Use of the method for the operation of a light amplifier according to one of Claims 1 to 8 for the control of, and/or as a separating filter for, the path direction (Figs. 8, 9, 12, 14).

**Revendications**

**1.** Procédé pour faire fonctionner un amplificateur de lumière comportant un trajet de rayonnement en forme d'arc de cercle ou en anneau dans le matériau, actif pour l'effet laser, de l'amplificateur de lumière, dans lequel la zone de pompage en forme d'arc de cercle ou en forme d'anneau, prévue sur la surface du matériau actif pour l'effet laser possède une largeur (B), cette zone de pompage produisant son action de pompage à une profondeur (D) du matériau actif pour l'effet laser,
selon lequel il existe un profil de distribution (15) de cette action de pompage, rapporté au trajet ($R_0$) du rayonnement, et le gradient (figure 2) du profil de l'action de pompage fournit un gradient, qui dépend de cette action, de l'indice de réfraction (n) du matériau actif pour l'effet laser et le maximum d'amplification ($G_{max}$) se situe à la fréquence de rayonnement ($f_0$) (figure 3),
caractérisé par le fait
que le rayonnement à phase pilotée est produit avec une fréquence $f_{1,2} = f_0 \pm \Delta f$ (figure 5) pour une amplification $g(f_{1,2})$ qui est inférieure à l'amplification maximale $g_{max}$ (figure 3) lorsque la largeur (B) et la profondeur (D) sont accordées l'une sur l'autre,
et l'on fait circuler ce rayonnement possédant la fréquence f = 1, 2 dans une gamme de rayons R = $R_0 \pm \Delta R$, qui s'établit pour cette fréquence de rayonnement et dans laquelle l'indice de réfraction n(R) = $n_0 \pm \Delta n$ (figure 6), modifié par l'action de pompage (figure 2), possède un indice de réfraction dont la variation se rapproche au moins de (-1/R), l'apparition du rayonnement étant évitée de la même manière que pour le rayonnement Tscherenkow sur cette trajectoire de rayonnement.

**2.** Procédé pour faire fonctionner un amplificateur de lumière suivant la revendication 1, selon lequel le pompage optique est exécuté dans le matériau optique pour l'effet laser le long d'une bande d'irradiation en forme d'arc de cercle.

**3.** Procédé pour faire fonctionner un amplificateur de lumière suivant la revendication 2, comportant deux zones coaxiales d'irradiation de forme annulaire ou au moins en forme d'arc de cercle, de la surface du matériau actif pour l'effet laser.

**4.** Procédé pour faire fonctionner un amplificateur de lumière suivant la revendication 1, selon lequel on réalise une injection de courant (j) dans le matériau semiconducteur (10) le long d'une bande réalisée sous la forme d'une électrode (214), le niveau de pompage étant dimensionné ou commandé par le courant d'injection (j).

**5.** Procédé de fonctionnement selon la revendication 1, 2 ou 3, comportant une trajectoire de rayonnement de forme circulaire ou en forme d'arc de cercle, c'est-à-dire pour laquelle R est localement constant.

**6.** Procédé pour faire fonctionner un amplificateur de lumière suivant l'une des revendications 4 ou 5, comportant deux électrodes coaxiales (14',14'') de forme annulaire ou au moins en forme d'arc de cercle, avec lesquelles une alimentation en courant séparée (figures 9, 10) est exécutée.

**7.** Procédé de fonctionnement suivant la revendication 4 ou l'une des autres revendications, selon lequel l'amplificateur de lumière est pourvu d'une électrode dentelée d'injection (1014, 2214, figure 10).

**8.** Procédé de fonctionnement selon la revendication 4 ou l'une des autres revendications, selon lequel l'amplificateur de lumière comporte, dans une structure intégrée à semiconducteurs, un système électronique de commande, un système électronique de modulation et/ou un système électronique d'évaluation.

**9.** Procédé pour faire fonctionner un amplificateur de lumière suivant les revendications 1 à 8, en tant que multiplexeur et/ou démultiplexeur (figures 8, 9, 12, 1).

**10.** Utilisation du procédé pour faire fonctionner un amplificateur de lumière suivant l'une des revendications 1 à 8, pour la commande de la direction du trajet et/ou la commande en tant que filtre d'aiguillage pour la direction du trajet (figures 8, 9, 12, 14).

# FIG 1

# FIG 2

# FIG 3

# FIG 6

# FIG 5

FIG 4

FIG 7

FIG 8

FIG 11

FIG 9

FIG 10

FIG 15

FIG12

FIG 13

FIG 14